Europäisches Patentamt

European Patent Office

Office européen des brevets

(19)

(11) Publication number: **0 455 284 A1**

# EUROPEAN PATENT APPLICATION

(21) Application number: 91200797.8

(22) Date of filing: 04.04.91

(51) Int. Cl.⁵: **C30B 31/22, H01L 21/285**

(30) Priority: 04.04.90 NL 9000795

(43) Date of publication of application:
**06.11.91 Bulletin 91/45**

(84) Designated Contracting States:
**AT BE CH DE DK ES FR GB GR IT LI LU NL SE**

(71) Applicant: **INTERUNIVERSITAIR MICROELEKTRONICA CENTRUM VZW**
**Kapeldreef 75**
**B-3030 Leuven-Heverlee(BE)**

(72) Inventor: **Maex, Karen Irma Jozef**
**Wijgmaelsesteenweg 136**
**B-3020 Herent(BE)**

(74) Representative: **Land, Addick Adrianus Gosling et al**
**OCTROOIBUREAU ARNOLD & SIEDSMA**
**Sweelinckplein 1**
**NL-2517 GK Den Haag(NL)**

(54) Method for applying metal silicides to silicon.

(57) Method for applying a layer or region of metal silicide to a silicon substrate comprising the following steps of:
-   implanting metal ions in a region of substantially mono-crystalline silicon;
-   depositing metal on the surface of a region of silicon; and
-   annealing a thus formed structure;
wherein a substantially mono-crystalline metal silicide is formed on the substantially mono-crystalline silicon.

FIG.1B

FIG.1A

FIG.1C

EP 0 455 284 A1

Metal silicides are frequently used in microelectronics as contacts, gate electrodes, connections and/or for making contact with buried metal silicides formed for example with ion bundle synthesis. According to the prior art metal is deposited onto silicon and an alloy of metal and silicon is then obtained at increased temperature.

Epitaxial growth is employed using MBE (Molecular Beam Epitaxy). This MBE technique is expensive and requires a great deal of time to apply relatively thick layers of metal silicides.

The present invention provides a method for applying a layer or region of metal silicide to a silicon substrate comprising the following steps of:
- implanting metal ions in a region of substantially mono-crystalline silicon;
- depositing metal on the surface of a region of silicon; and
- annealing a thus formed structure;
wherein a substantially mono-crystalline metal silicide is formed on the substantially mono-crystalline silicon.

According to the present invention epitaxial metal silicides can be formed in a relatively simple manner, using heat treatment (annealing) and a deposition method for metal.

According to the present invention it is further possible to apply epitaxial layers on every Si substrate independent of the orientation of the substrate.

According to preferred embodiments of the present invention the CoSi$_2$/Si interface is automatically flat.

The present invention also provides a structure of metal silicide (and CoSi$_2$) on Si.

The technique according to the present invention enables the applying of patterns using a mask as known from the semiconductor art; this also in the case of relatively thick layers (greater than 100 nm).

In preference cobalt is used as metal and CoSi$_2$ is formed, as the crystal structure of the CoSi$_2$ and Si connect well to one another.

Further advantages, features and details of the present invention will become apparent in the light of a description of preferred embodiments thereof with reference to the annexed drawing, in which:
fig. 1A-C show a first preferred embodiment of the method according to the present invention;
fig. 2A-C show a second preferred embodiment of the method according to the present invention; and
fig. 3A and 3B show a third embodiment of the method according to the present invention; and
fig. 4A and 4B show a fourth embodiment according to the present invention.

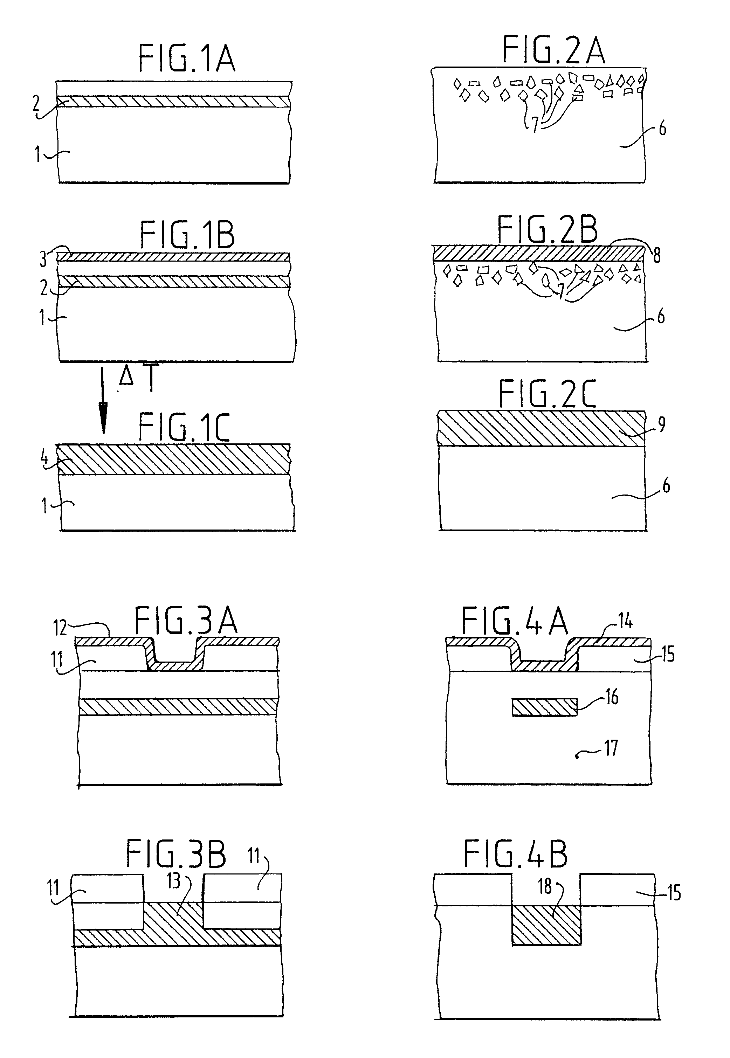

Using a cobalt implantation of 2.5 x 10$^{17}$ cobalt atoms per cm$^2$ at 200 keV and 400°C and a heat treatment at 600°C for 45 minutes and an optional application of a (thin) covering layer of oxide in order to prevent evaporation of Si atoms, a buried layer of CoSi$_2$ 2 (fig. 1A) is formed in a silicon substrate 1 with <100> or <111> orientation. A 40 nm thick Co layer 3 (fig. 1B) is subsequently deposited onto the top surface of substrate 1. After a heat treatment at 550°C and etching of the cobalt, a temperature of 900°C ($\Delta$T in fig. 1C) is then applied for 30 seconds, whereafter an epitaxially aligned layer 4 of CoSi$_2$ is formed on substrate 1. This was demonstrated using RBS (Rutherford Back Scattering) technique and TEM (Transition Electron Microscope) techniques. The measured thickness of the layer 4 is 220 nm.

In a second embodiment (fig. 2A-2C) cobalt is implanted in a substrate 6 of substantially mono-crystalline silicon at a density of 10$^{17}$ Co atoms per cm$^2$ at 100 keV and heat treatment at 600°C for 45 minutes. This results in seed regions 7 in the substrate.

A 20 nm thick layer 8 of cobalt is then applied to the substrate and an epitaxial layer of CoSi$_2$ is obtained by a short heat treatment at 900°C for thirty seconds.

In the structures shown in fig. 3A, 3B and fig. 4A, 4B use is made of a mask 11 and 12 respectively and a dose of cobalt atoms of 5 x 10$^{16}$ atoms per cm$^2$ at 50 keV.

By arranging the mask after implantation (fig. 3A, 3B), after deposition of a 20 nm thick cobalt layer 15 and subsequent heat treatment at 900°C for thirty seconds, a reversed T-shaped region 13 of mono-crystalline CoSi$_2$ is obtained, the extremities of which extend underneath the mask.

If a layer of cobalt 14 (fig. 4A, 4B) is applied to a substrate 17 in which is formed a region 16 of implanted CoSi$_2$ defined by the mask 15, there results after the above stated heat treatment a region 18 which extends only in the area where the mask has an opening.

The shown islands of CoSi$_2$ are obtained without the CoSi$_2$ having to be etched away.

The present invention is not limited to the above embodiments. For forming metal silicides the elements Y (yttrium), Er (erbium), Cr (chromium) or Ni (nickel) can be used, of which it is known that they can form with silicon an epitaxial metal silicide. The method and structure according to the annexed claims is not limited to forming of relatively thick CoSi$_2$ layers; further developments can also result in the forming of thinner layers.

Further research seeks to keep the dose of cobalt ions as low as possible with respect to cost price and the like. The low doses are preferably applied in all the preferred embodiments shown.

**Claims**

1. Method for applying a layer or region of metal silicide to a silicon substrate comprising the following steps of:
   - implanting metal ions in a region of substantially mono-crystalline silicon;
   - depositing metal on the surface of a region of silicon; and
   - annealing a thus formed structure;
   wherein a substantially mono-crystalline metal silicide is formed on the substantially mono-crystalline silicon.

2. Method as claimed in claim 1, wherein the metal is cobalt and the metal silicide $CoSi_2$.

3. Method as claimed in claim 1 or 2, wherein the annealing takes place in a temperature range of 800-1200 $^\circ$C, preferably 1000 $^\circ$C for a time period of 15-90 seconds and preferably 30 seconds.

4. Method as claimed in claim 1 or 2, wherein the implantation dose of cobalt amounts to 2.5 x $10^{17}$ atoms per $cm^2$ or less, preferably less than $10^{17}$ atoms per $cm^2$ and more preferably approximately 5 x $10^{16}$ atoms per $cm^2$ or less.

5. Structure of metal silicide on a silicon substrate wherein the pattern of the structure can be applied thereto using a mask.

6. Structure as claimed in claim 5, wherein the mask serves to define the $CoSi_2$ region for implantation.

7. Method for forming a structure as claimed in claim 5 or 6, wherein use is made of ion-assisted sputtering.

FIG.1A

FIG.2A

FIG.1B

FIG.2B

ΔT

FIG.1C

FIG.2C

FIG.3A

FIG.4A

FIG.3B

FIG.4B

## DOCUMENTS CONSIDERED TO BE RELEVANT

| Category | Citation of document with indication, where appropriate, of relevant passages | Relevant to claim | CLASSIFICATION OF THE APPLICATION (Int. Cl.5) |
|---|---|---|---|
| Y | APPLIED PHYSICS LETTERS, vol. 50, no. 4, 26th January 1987, pages 174-176, New York, NY, US; H.C. CHENG et al.: "Growth of single-crystalline CoSi2 on (111) Si in solid phase epitaxy regime by a nonultrahigh vacuum method" * Page 174 * | 1-4 | C 30 B 31/22 H 01 L 21/285 |
| Y | NUCLEAR INSTRUMENTS & METHODS IN PHYSICS RESEARCH, vol. B39, nos. 1-4 + index, 2nd March 1989, pages 276-279, Amsterdam, NL; K. KOHLHOF et al.: "Formation of buried epitaxial Co silicides by ion implantation" * Pages 276,277 * | 1-4 | |
| X | IEEE TRANSACTIONS ON ELECTRON DEVICES, vol. ED-34, no. 3, March 1987, pages 548-553, New York, US; M. TABASKY et al.: "Direct silicidation of Co on Si by rapid thermal annealing" * Page 550 * | 5 | |
| Y | IDEM | 7 | |
| Y | FR-A-2 250 198  (RCA CORP.) * Claim 1 * | 7 | TECHNICAL FIELDS SEARCHED (Int. Cl.5) C 30 B H 01 L |
| X | EP-A-0 214 515  (IBM CORP.)(18-03-1987) * Column 4, lines 1-26; claims 1,2 * | 5,7 | |

The present search report has been drawn up for all claims

| Place of search | Date of completion of search | Examiner |
|---|---|---|
| The Hague | 08 August 91 | COOK S.D. |

CATEGORY OF CITED DOCUMENTS

X : particularly relevant if taken alone
Y : particularly relevant if combined with another document of the same catagory
A : technological background
O : non-written disclosure
P : intermediate document
T : theory or principle underlying the invention

E : earlier patent document, but published on, or after the filing date
D : document cited in the application
L : document cited for other reasons

& : member of the same patent family, corresponding document